# EUROPEAN PATENT APPLICATION

(11) **EP 4 819 392 A1**
(43) Date of publication of application: **07.10.2026**
(21) Application number: 25168637.4
(22) Date of filing: 04.04.2025
(51) Int. Cl.: H01R 9/05, H01R 13/00, H01R 4/34

(54) **CONNECTOR AND ELECTRICAL ASSEMBLY FOR A COOLED ELECTRICAL CABLE**

(71) Applicant: TE Connectivity Solutions GmbH, 8200 Schaffhausen (CH)
(72) Inventor: DOMKE, Daniel, 8200 Schaffhausen (CH)
(74) Representative: Grünecker Patent- und Rechtsanwälte PartG mbB

(57) **Abstract**

A connector (100) for electrically and fluidly connecting a cooled electrical cable (110) to a cooled busbar (140) is disclosed. The connector (100) includes a terminal body (120); a busbar coupling (180) configured to couple the terminal body (120), at an orifice (124) thereof, to the cooled busbar (140); and a clamp (160). The terminal body (120) includes: a first and second orifice (122, 124); a channel (150) extending through the terminal body (120), the channel (150) connecting the first and second orifices (122, 124). The channel (150) can pass a coolant (130) between the cooled electrical cable (110) and the cooled busbar (140). The terminal body (120) includes a hose fitting (190) for coupling the terminal body (120) to a hose (118) of the cooled electrical cable (110), the hose fitting (190) including the first orifice (122). The clamp (160) can sandwich an annularly disposed electrical conductor (116) of the cable (110) between the clamp (160) and the terminal body (120) adjacent to the hose fitting (190).

## Description

Cooling can be done for high power electrical applications in order to increase safety and efficiency. For example, cooling can be done for electrical systems by fluid coolants which transit through paths adjacent to conductors, carrying heat away from the conductors. It can be challenging to maintain close spatial proximity between conductive elements and cooling elements of a system. It is additionally challenging to have effective cooling while maintaining a compact structure.

Herein is disclosed a connector and electrical assembly for a cooled electrical cable, such as a high voltage cable with fluid cooling. The connector and assembly described herein can efficiently cool the circuit, for example by maintaining close proximity between electrically conductive elements and heat exchanging and/or cooling elements. The connector described herein, in various embodiments, can aid in efficient cooling of an electrical circuit that includes a cooled electrical cable and, for example, a cooled busbar.

A connector for electrically and fluidly connecting a cooled electrical cable to a cooled busbar is disclosed. The connector includes a terminal body, a busbar coupling, and a clamp. The terminal body includes a first and second orifice; a channel extending through the terminal body, the channel connecting the first and second orifices, the channel for passing a coolant between the cooled electrical cable and the cooled busbar; and a hose fitting for coupling the terminal body to a hose of the cooled electrical cable, the hose fitting including the first orifice. The busbar coupling is configured to couple the terminal body, at the second orifice, to the cooled busbar. The clamp is for sandwiching an annularly disposed electrical conductor of the cable between the clamp and the terminal body adjacent to the hose fitting. The connector can allow efficient cooling of the components, e.g. the electrical cable, the connector, and the busbar. For example, the conductor of the electrical cable can be annularly disposed around the hose fitting and/or at least part of the channel, which can allow efficient heat transfer to the coolant.

The above connector may be further improved by adding one or more of the features described in the following, whereby each of these features is advantageous in itself, and may be combined independently and/or in any desired manner with any of the other features described in the following.

The connector can have a mating direction which is the direction for mating the hose to the hose fitting. The mating axis is along the mating direction and may go through the center of the first orifice.

The terminal body can include an electrical contact surface, which can be an outer surface of the terminal body adjacent to the hose fitting. The electrical contact surface can be for electrical contact with the annularly disposed electrical conductor of the cable.

The hose fitting and the electrical contact surface can be adjacent, e.g. adjacent along the mating direction. This can provide for a compact connector that generates less resistive heat from the conductor of the electrical cable.

There can be a second clamp for sandwiching the hose and the annularly disposed electrical conductor between the second clamp and the hose fitting.

The electrical contact surface can have an annular cross section, in a plane perpendicular to the mating axis. This allows for a good fit with an annularly disposed electrical conductor.

The clamp can provide a radially inward force toward an electrical contact surface of the terminal body. This can provide good electrical contact and mechanical attachment.

The hose fitting can have the first orifice at a first end and the electrical contact surface at the other end. The electrical contact surface can be adjacent the hose fitting. This provides a compact structure to minimize the amount of electrical cable, which can reduce the amount of resistive heat generated.

The clamp can press the conductor of the electrical cable onto the electrical contact surface. The clamp can be a ferrule. The clamp can provide a force directed radially toward the mating axis. The clamp can be configured for crimping the annularly disposed electrical conductor to the electrical contact surface. The clamp may additionally provide force on the cable for sealing the hose of the cable to the hose mating surface. The mating can be irreversible, such as if the clamp is irreversibly crimped.

A width of the clamp, parallel to the mating direction, can match a length of the electrical contact surface along the mating direction.

The electrical contact surface can be a metal finish. The electrical contact surface can be electrodeposited and/or polished. The electrical contact surface can include at least one of: copper, aluminum, nickel, gold, or tin.

The hose fitting can be inserted into the hose, e.g. along the mating direction. When mated, there is fluid coupling, with the hose extending around the first orifice.

A hose mating surface of the hose fitting can be annular, in a cross-section perpendicular to the mating axis. The hose mating surface can have a smaller diameter than the electrical contact surface; there can be a step between the surfaces. This can allow for a good mechanical connection, seal, and/or electrical connection of the hose and annularly disposed electrical conductor of the cooled electrical cable onto the connector.

The electrical contact surface can have a constant diameter and extends along the mating axis. A constant diameter can provide a robust mechanical attachment. The hose mating surface of the hose fitting can be barbed and/or include one or more barbs. This can improve the mating connection. The mating surface of the hose fitting can make contact with an inside wall of the hose. Corrugations can, alternatively/additionally, be configured to abut the inside wall of the hose of the cooled electrical cable.

The busbar coupling can be configured for fluidly and sealingly coupling the second orifice to the cooled busbar. The busbar coupling can reversibly couple the busbar to the terminal body.

The busbar coupling can include, annularly disposed around a coupling axis, at least one of: an o-ring, an annular spring, or a washer(s). The sealing and/or electrical contact can be ensured.

The coupling axis can pass through the second orifice. The terminal body can couple to the cooled busbar along the coupling axis. The coupling axis can pass through the center of the channel at the second orifice.

At least one of the o-ring or the annular spring can be disposed annularly around the channel. At least one of the o-ring or the annular spring can be configured to form a seal with the cooled busbar. The annular spring can be for conductive coupling, e.g. to form an electrical contact between the cooled busbar and the connector. The annularly spring can be a contact spring.

At least one of the o-ring or the annular spring can be separated from the channel by a cylindrical conduit of the terminal body. The conduit can extend to the second orifice. The sealing and/or electrical contact can be thereby ensured.

The conduit can be inserted into busbar.

The washer(s), when present, can include copper. The washer(s) may deform upon coupling of the connector and the busbar. Copper can form a good mechanical connection and conductive interface.

The busbar coupling can include a bolt that extends parallel to the coupling axis for fastening the connector to the cooled busbar. The bolt may pass through a flange that is joined to or integral with the terminal body. The bolt may be screwed into the busbar, for coupling the connector to the busbar.

For example, the connector can include a bolt which extends along the coupling axis, through the second orifice, and includes a duct. The duct can pass the coolant between the cooled electrical cable and the cooled busbar. This may provide for a compact arrangement with good heat transfer properties from the conductive path to the coolant.

The duct can lead to an opening for passing coolant between the busbar and the duct. The duct of the bolt can be at least partially within the channel of the terminal body.

The bolt may pass through a washer between the terminal body and the busbar. Alternatively/additionally, the bolt may pass through a washer between the head of the bolt and the terminal body.

A connection assembly is disclosed herein, which includes the connector, the cooled busbar, and the cooled electrical cable which includes the hose and the electrical conductor. The electrical conductor can be annularly disposed around the hose, the hose fitting and the electrical contact surface. The electrical conductor of the cooled electrical cable can extend to the electrical contact surface of the terminal body of the connector and the clamp.

The conductor can extend past the hose where the hose ends at the hose fitting.

The connection assembly may also include, for example, a housing which includes an opening through which the hose and the electrical conductor of the cooled electrical cable passes to the connector.

In the following, the invention will be explained exemplarily and in more detail with reference to the drawings and in accordance with several embodiments, the different features of which can be combined with one another as desired in accordance with the above general description. Moreover, a feature may be omitted from the below embodiments if its technical effect is not required in a particular application. Likewise, a feature described above that is not present in an embodiment as described below may be added if its technical effect is not essential for a particular application.

In the following, the same reference numerals are used for elements that correspond to each other with respect to at least one of structure and function.
Fig. 1 shows a cross section of a connection assembly, according to an embodiment;
Fig. 2 shows a cross section of a connector, according to an embodiment;
Fig. 3 shows a cross section of a cooled electrical cable, according to an embodiment;
Fig. 4 shows a cross section of a connection assembly, according to an embodiment; and
Fig. 5 shows a cross section of a connection assembly, according to an embodiment.

In the following, a connection assembly, connector, and components thereof, according to several possible embodiments, will be described with reference to the figures, which are illustrative. Embodiments are not limited to those shown in the figures.

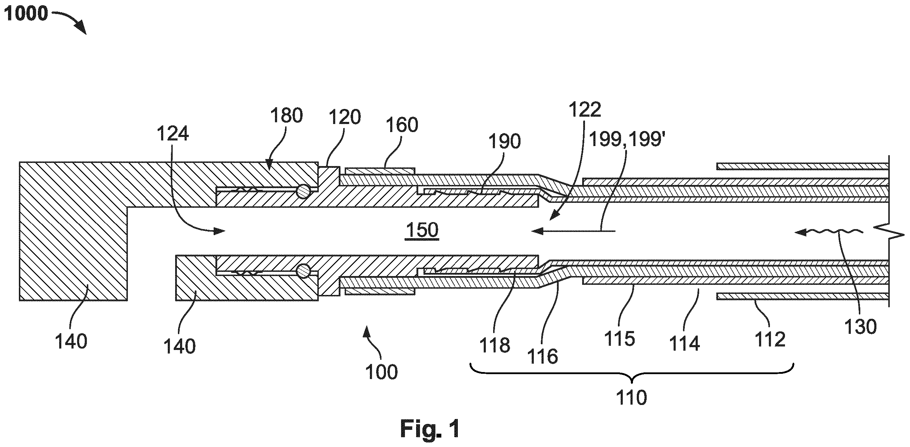

Fig. 1 illustrates a connection assembly, in cross section, according to an embodiment. The connection assembly 1000 can include a connector 100 that can electrically and fluidly connect a cooled electrical cable 110 to another component, such as a cooled busbar 140. The connection assembly 1000 can include the cooled cable 110, the cooled busbar 140, and the connector 100.

The connector 100 can include a terminal body 120, which may have a first and second orifice 122, 124. A channel 150 can extend through the terminal body 120. The channel 150 can connect the first and second orifices 122, 124. A coolant 130 can pass through the channel 150 between the cooled electrical cable 110 and the cooled busbar 140. For example, the coolant 130 can pass from the first 122 to the second orifice 124.

The connector 100 can include a hose fitting 190, which can be part of the terminal body 120. The hose fitting 190 can be attached to the terminal body 120. The hose fitting 190 can be monolithically formed with the terminal body 120.

The hose fitting 190 can be for mating the terminal body 120 to a hose 118 of the cooled electrical cable 110. The hose fitting 190 can include the first orifice 122. The mating of the terminal body 120 and hose 118 can occur along a mating axis 199'. For example, the hose fitting 190 is inserted into the hose 118 along the mating axis 199'. A mating direction 199, which is parallel to the mating axis 199', can be toward the terminal body 120, e.g. along the end of the cable 110 that mates with the connector 100. The mating direction 199 is the direction for mating the hose 118 to the hose fitting 190. The mating direction 199 and/or mating axis 199' can pass through the first orifice 122, such as the center thereof.

The hose fitting 190 can be configured for insertion into the hose 118 along the mating axis 199'. Alternatively/additionally, the hose fitting 190 is configured for fluid coupling with the hose 118. The hose 118 can extend around the first orifice 122 when the hose 118 and hose fitting 190 are mated.

The connector 100 can include a busbar coupling 180, which couples the terminal body 120, at the second orifice 124, to the cooled busbar 140. The busbar coupling 180 can fluidly and sealingly couple the second orifice 124 to the cooled busbar 140. The coupling between the busbar coupling 180 and the busbar 140 can be reversible.

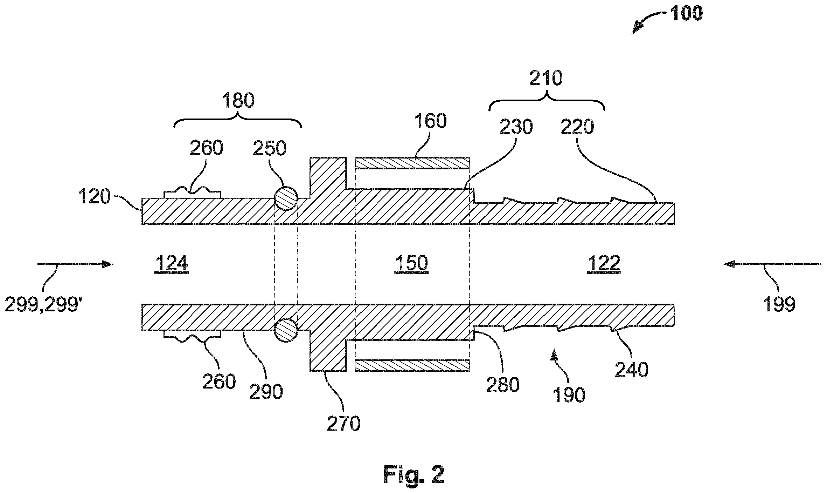

Fig. 2 illustrates a connector, in cross section, according to an embodiment. The embodiments described with reference to Fig. 2 can be based on those described with reference to Fig. 1. A coupling axis 299' can be an axis along which the connector 100 is coupled to the busbar 140, e.g. reversibly coupled.

A coupling axis 299', along which the busbar 180 and the terminal body 120 are coupled, can pass through the second orifice 124, e.g. where the terminal body 120 couples to the cooled busbar 140. The coupling axis 299' can pass through the center of the second orifice 124. The coupling axis 299' can be collinear and/or parallel to the mating axis 199', e.g. when the channel 150 is straight through the terminal body 120.

The busbar coupling 180 can include at least one of an o-ring 250, an annular spring 260, or a washer. The o-ring 250 and/or annular spring 260 can aid in fluidly sealing the connector 100 with the busbar 140. Alternatively/additionally, the annular spring 260 can aid in providing electrical contact between the busbar 140 and the terminal body 120. The o-ring 250, annular spring 260, and/or washer can be annularly disposed around the coupling axis 299'.

The o-ring 250 and/or the annular spring 260 can be disposed annularly around the channel 150. Alternatively/additionally, at least one of the o-ring 250 or the annular spring 260 is configured to form a seal with the cooled busbar 140, e.g. a fluid seal for coolant 130, e.g. that is sealed. The o-ring 250 and/or annular spring 260 can seal the busbar 140 and terminal body 120 at the coupling so that coolant 130 can pass between the terminal body 120 and the busbar 140.

The o-ring 250 and/or annular spring 260 can be separated from the channel 150 by a cylindrical conduit 290 of the terminal body 120. The cylindrical conduit 290 can extend to the second orifice 124. The o-ring 250 and/or annular spring 260 can be between the outside surface of the cylindrical conduit 290 and the cooled busbar 140. The cylindrical conduit 290 can be inserted into the cooled busbar 140.

The connector 100 and/or busbar coupling 180 can include a flange 270, which can provide a stopping surface for the busbar coupling 180 and/or an annularly disposed electrical conductor 116 of the cable 110. For example, the flange 270 can abut the busbar 140 when the connector 100 is coupled to the busbar 140, e.g. by insertion of the cylindrical conduit 290 into the cooled busbar 140. The flange 270 may, alternatively/additionally provide a stopping surface for the end of the annularly disposed conductor 116 of the cable 110.

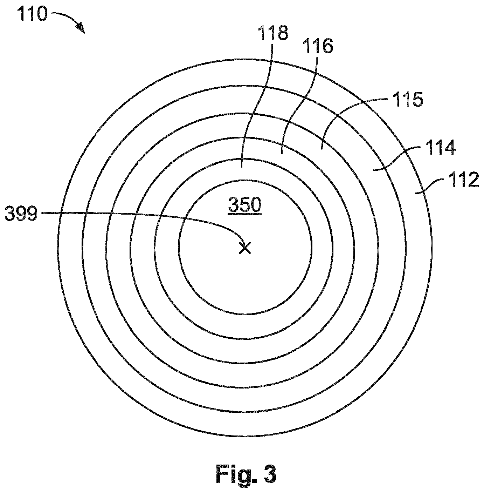

Fig. 3 illustrates, according to an embodiment, a cooled electrical cable, in cross-section. The embodiments described with reference to Fig. 3 can be based on those described with reference to Fig. 1 and/or Fig. 2. The cooled cable 110 can include the hose 118 and the conductor 116. The conductor 116 can be suitable for high voltage applications, such as for electrical vehicles. The conductor 116 can include multiple strands. The conductor 116 can include braided strands. The conductor 116 can be annularly disposed, e.g. around a longitudinal axis 399 of the cable 110. The hose 118 can define a coolant channel 350 through which coolant 130 is passed.

When the cable 110 is mated to the connector 100, the coolant channel 350 of the electrical cable 110 is connected to the channel 150 of the terminal body 120. The mating of the cable 110 and the connector 100 can be such that the mating axis 199' of the connector 100 and the longitudinal axis 399 of the cable 110 are collinear, and/or are the same axis.

The coolant 130 can be nonconductive fluid such as a silicone oil, which can reduce the risk of electrical shorts. The coolant 130 can pass through the coolant channel 350 of the cooled electrical cable 110, and transfer heat therefrom, e.g. absorb heat from the annularly shaped conductor 116, which may lie directly adjacent, radially, to the outer wall of the hose 118. The radial directions are perpendicular to the long axis 399 of the cable 110. The long axis 399 can go through the center of the cooled electrical cable 110.

The hose 118 can include Teflon and/or polytetrafluorethylene, which can resist chemical corrosion and/or decomposition. The conductor 116 can include at least one of copper or aluminum, for relatively low electrical resistance.

The cooled cable 110 can additionally include at least one of an insulator 115 (e.g. an inner insulator that can be between the conductor 116 and a shield 114), a shield 114 (e.g. a shield mesh, which can be conductive), or a cable sheath 112 (e.g. an outer insulation). The cross-sections (in a plane perpendicular to the long axis 299' of the cable 110) of the hose 118, cable conductor 116, insulator 115, shield 114, and/or sheath 112 are annular. Alternatively/additionally, the hose 118, cable conductor 116, insulator 115, shield 114, and/or sheath 112 are disposed, e.g. concentrically, e.g. about the longitudinal axis 299 of the electrical cable 110, which can pass through the center of the cable 110 and/or coolant channel 350.

The connector 100 and/or connection assembly 1000 can include a clamp 160 for sandwiching the annularly disposed electrical conductor 116 of the cable 110 between the clamp 160 and the terminal body 120 adjacent to the hose fitting 190. For example, the hose fitting 190 has the first orifice 122 at a first end and the electrical contact surface 230 at the other end. The electrical contact surface 230 can be adjacent to the hose fitting 190 at the end of the hose fitting opposite to the first orifice 122.

The clamp 160 can be a ferrule. A ferrule can provide a radially inward force, e.g. when the ferrule is crimped, e.g. by mechanical or electromagnetic means, e.g. with an electromagnetic pulse. For example, the clamp 160 can fix the annularly disposed electrical conductor 116, and electrically mate the conductor 116, to the terminal body 120 by electromagnetic pulse technology (EMPT). The clamp 160 can be crimped by EMPT and/or by a mechanical crimping.

The terminal body 120 can include an electrical contact surface 230, which can be an outer surface adjacent to the hose fitting 190. The electrical contact surface 230 is configured for electrical contact with the annularly disposed electrical conductor 116 of the cable 110. The electrical contact surface 230 can be annularly disposed around the channel 150. Along the mating direction 199, the hose fitting 190 can be adjacent to the electrical contact surface 230. The electrical contact surface 230 can have an annular cross section, in a plane perpendicular to the mating axis 199'.

The clamp 160 can provide a radially inward force toward an electrical contact surface 230 of the terminal body 120. The radially inward force can be directed toward the mating axis 199. Alterantively/additioanlly, the clamp 160 presses the conductor 116 onto the electrical contact surface 230 of the terminal body 120.

The hose fitting 190 can include a hose mating surface 220. The hose mating surface 220 and the electrical contact surface 230 can be adjacent to each other, e.g. along the mating axis 199'. The hose mating surface 220 and the electrical contact surface 230 can be separated by a step 280, e.g. an annular step. The outer diameter of the hose mating surface 220 can be smaller than the outer diameter of the electrical contact surface 230. The step and/or difference in outer diameter can allow for a good connection for an annularly disposed electrical cable conductor 116, which is annularly disposed around the outside of the hose 118. Mechanical strain in the conductor 116 can be reduced. The step 280 can have a height that corresponds to the wall thickness of the hose 118.

Additionally, the clamp 160 can be configured for providing a compressive force on the cable 110 for sealing the hose 118 of the cable 110 to the hose mating surface 220. Alternatively/additionally, a second clamp can sandwich the hose 118 and the second clamp for sandwiching the hose 118 and the annularly disposed electrical conductor 116 between the second clamp and the hose fitting 190. The clamp 160 can be located around the the electrical contact surface 230. The optional second clamp can be located around the hose mating surface 220. The clamp 160 is for electrically mating the conductor 116 of the cable 110 and the terminal body 120; the clamp 160 may additionally fluidly seal the hose 118 and the hose fitting 190. The optional second clamp is for fluidly sealing the hose 118 and the connector 100. Omitting the optional second clamp can aid in speeding up the manufacturing/connection process. Including the optional second clamp can provide redundancy to the fluid seal.

The clamp 160 can ensure electrical contact between the annularly disposed electrical conductor 116 to the electrical contact surface 230. The clamp 160 can directly abut the outer surface of the annularly disposed conductor 116 of the cooled electrical cable 110. Alternatively/additionally, the annularly disposed conductor 116, at its radially inner surface, can directly abut the electrical contact surface 230. The clamp 160 can function by a crimping action. The clamp 160 can be a crimping member and/or ferrule.

The width of the clamp 160, parallel to the mating axis 199', can match a length of the electrical contact surface 230 along the mating direction 199'. Matching widths can provide evenly distributed force so that electrical contact is robust. Matching widths may also aid in the fluid seal between the hose 118 and the hose fitting 190.

The electrical contact surface 230 can have a constant diameter along the mating axis 199'. This can aid in providing a robust mechanical connection among the clamp 160, the annularly disposed electrical conductor 116, and the electrical contact surface 230. This can alternatively/additionally aid in providing a robust electrical contact.

The electrical contact surface 230 can include a metal finish, such as a metal finish that includes at least one of copper, aluminum, nickel, tin, or gold. Gold is highly conductive, soft, and inert to corrosion. Copper is highly conductive and relatively soft so that the electrical contact can be robust. Aluminum is relatively inexpensive and a good conductor. Nickel aids in mechanical durability. Tin can aid in forming alloys, and is a soft conductor. The optional metal finish of the electrical contact surface 230 can be electrodeposited; alternatively/additionally, the optional metal finish can be applied over the terminal body 120 and/or hose fitting 190, in addition to the electrical contact surface 230. Softness may be desirable for making good electrical contact between the electrical conductor 116 of the cable 110 and the electrical contact surface 230, via the compression of the clamp 160.

The electrical contact surface 230 and hose mating surface 220 can be disposed, annularly, along the mating axis 199'. The hose mating surface 220 can have a smaller diameter than the electrical contact surface 230. The difference of diameters ( of the hose mating and electrical contact surfaces 220, 230) can accommodate the annularly disposed conductor 116 and hose 118, e.g. due to the inner diameter of the conductor 116 being greater than the inner diameter of the hose 118.

The proximity of the electrical contact surface 230 and hose mating surface 220 to each other can aid in reducing electromagnetic interference (EMI). The annularly disposed conductor 116 can be electrically mated to the connector 100 with minimal deformation of the conductor 116. By reducing the deformation, EMI can be reduced, including when the conductor 116 includes braided strands.

The hose mating surface 220 of the hose fitting 190 can abut the inside of the hose 118, e.g. the inside wall of the hose 118. The mating can be irreversible in the sense that removing the hose will damage the hose. The hose mating surface 220 of the hose fitting 190 can include one or more corrugations and/or one or more barbs 240, which can aid in providing a robust connection and/or robust fluid seal. Corrugations and/or barbs 240 can abut an inside wall of the hose of the cable.

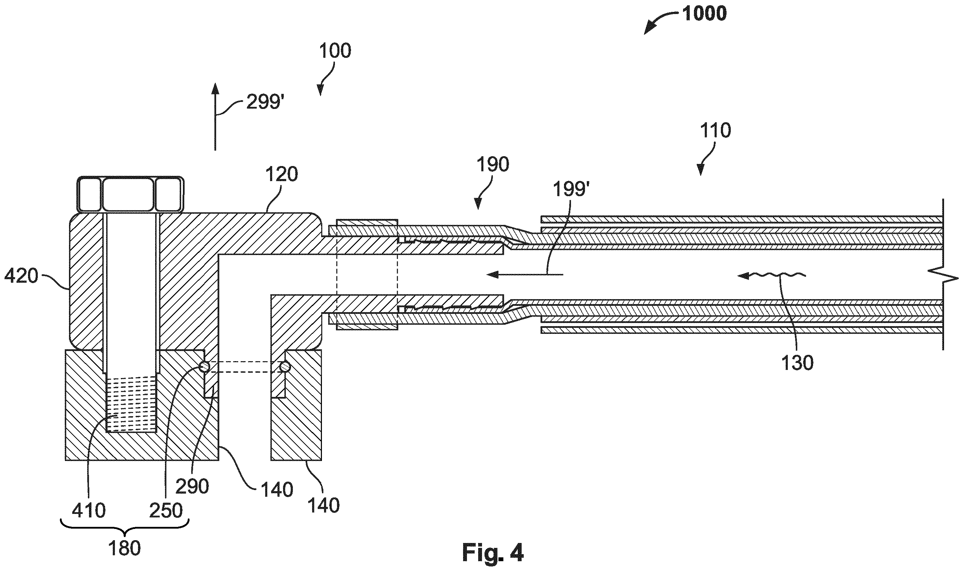

Fig. 4 illustrates a connector assembly, according to an embodiment. The connector assembly 1000 includes the connector 100, cable 110, and busbar 140. The connector assembly 1000 and connector 100 described with reference to Fig. 4 can include the features of the previously described embodiments, which may make reference to the previous figures.

As illustrated in the embodiment shown in Fig. 4, the busbar coupling 180 can include a bolt 410, for fixing the connector 100 to the busbar 140. The busbar coupling 180 that includes the bolt 410, as described herein, can include the various embodiments of the hose fitting 190, and the various embodiments of the clamp 160 and/or electrical contact surface 230.

The bolt 410 can fix a flange 420 of the connector 100 and/or terminal body 120 to the busbar 140. The bolt 410 can also provide a conductive pathway between the terminal body 120 and the busbar 140.

The bolt 410 can extend parallel to the coupling axis 299' and/or along the coupling axis 299'. The bolt 410 can extend through the flange 420. The flange 420 can be joined to or integral with the terminal body 120. The bolt 410 can be screwed into the busbar 120.

The channel 150 can have a bend. There can be an nonzero angle, such as a 90° angle between the coupling axis 299' and the mating axis 199'. Having a nonzero angle can allow the connector 100 to be used in devices having geometries that make it difficult or impossible to have straight coolant flow between the cable 110 and the busbar 140.

As illustrated in Fig. 4, the bolt 410 extends parallel to the coupling axis 299' for fastening the connector 100 to the cooled busbar 140.

As illustrated in Fig. 4, the busbar coupling 180 can include the o-ring 250. The terminal body 120 can include the cylindrical conduit 290, which can aid in providing a sealed passageway for the coolant 130 and the cylindrical conduit 290 of the terminal body 120.

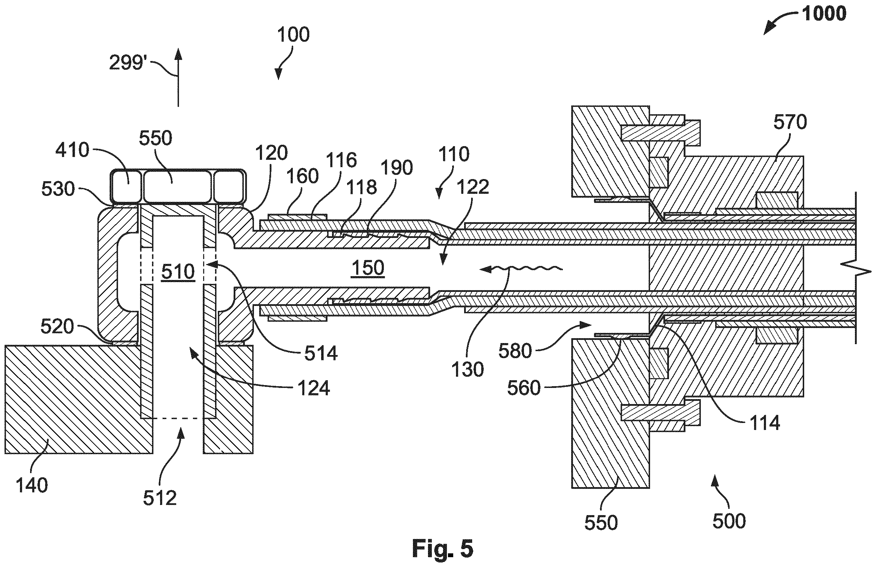

Fig. 5 illustrates, according to an embodiment, a connector assembly. The connector assembly 1000 includes the connector 100, cable 110, and busbar 140. The connector assembly 1000 and connector 100 described with reference to Fig. 5 can include the features of the previously described embodiments, which may make reference to the previous figures.

The optional bolt 410 of the busbar coupling 180 of the connector 100 can extend along the coupling axis 299', as is shown in Fig. 5. The busbar coupling 180 can also include at least one washer 520, 530, such as a washer 520 for the interface between the terminal body 120 and the busbar 140 and/or a washer 530 for the interface between a head 540 of the bolt 410 and the terminal body 120.

The washer(s) 520, 530 can include copper, which can provide a low resistance current pathway and/or aid in providing a robust mechanical connection. Aluminum alloys may alternatively/additionally be used to reduce cost. The washer(s) 520, 530 can deform when the connector 100 is coupled to the busbar 140. Deformation may improve mechanical stability and/or improve electrical contact.

The bolt 410 can include a duct 510 which can pass the coolant 130 between the cooled electrical cable 110 and the cooled busbar 140. The bolt 410 can pass through the second orifice 124 of the terminal body 120. The duct 510 can fluidly couple the channel 150 of the terminal body 120 and the cooled busbar 140. The bolt 410 can be inserted into the busbar 140 and screwed therein, e.g. with the duct 510 leading into the cooled busbar 140, e.g. along the coupling axis 299'. The bolt 410 can pass through the washer(s) 520, 530.

The duct 510 of the bolt 410 can pass at least partially through the channel 150 of the terminal body 120.

Having a bolt 410 with a duct 510 can reduce the size of the connection assembly 1000. The duct 510 can include an orifice 512 which is configured to lead into the busbar 140, e.g. into a channel of the busbar for the coolant 130. The orifice can be at the axial tip of the bolt 410. A second orifice 514 of the bolt 410 can be configured to lead to the channel 150 of the terminal body 120. The second orifice 514 can be within the channel 150 of the terminal body 120. At least part of the duct 510 of the bolt 410 can extend within the channel 150 of the terminal body 120.

The connector 100 described herein can attach to the hose 118 and annularly disposed conductor 116 of the cooled electrical cable 110. The cable 110 can include additional components, e.g. those described with reference to Fig. 3, such as any one or more of the optional outer layers, the insulator 115, cable shield 114, and cable sheath 112.

The connection assembly 1000 described herein can include the connector 100, the cooled busbar 140, and the cooled electrical cable 110. The electrical conductor 116 of the cooled electrical cable 110 can be annularly disposed around the hose 118, and extend along the hose 118, and extend to the electrical contact surface 230 of terminal body 120 and the clamp 160.

For example, the connection assembly 1000 can include the connector 100; the cooled busbar 140; and the cooled electrical cable 110 which includes the hose 118 and the electrical conductor 116. The electrical conductor 116 can be annularly disposed around the hose 118, the hose fitting 190, and the electrical contact surface 230. The electrical conductor 116 can extend to the electrical contact surface 230 of the terminal body 120 of the connector 100, and the clamp 160.

The connection assembly 1000 can include additional components of the cooled electrical cable 110, e.g. those described with reference to Fig. 3. Alternatively/additionally, the connection assembly 1000 can include additional components of a housing assembly 500, such as that depicted in Fig. 5. The housing assembly 500 can aid in isolating the connector 100 from the environment. The housing assembly 500 can be used with any embodiment of connection assembly 1000 and/or connector 100 described herein, and is not limited to the combination with the particular embodiment of the connector 100 shown in Fig. 5 or described with reference to Fig. 5.

The connection assembly 1000 can include the housing assembly 500, which can include a housing 550. The cooled electrical cable 110 can include the shield 114 which can be coupled to the housing 550 by a shield coupling 560, such as a weld. A safety block 570 can be fixed, e.g. bolted, to the outside of the housing 550. The safety block 570 can block direct access to the exposed conductor 116 of the cable 110. The cooled electrical cable 110 can pass into the safety block 570 and at least the hose 118 and conductor 116 pass through the wall of the housing 550 to the connector 100. The housing 550 can enclose the connector 1000 and busbar 140 therein. The housing 550 can enclose various electrical devices, such as an electric motor, invertor, power distribution unit and/or electrical axle.

The connector 100 and connection assembly 1000, as described herein, can enable efficient cooling of electrical circuits, especially those operating at high voltage and high current, such as for electric motors, invertors, power distribution units and/or electrical axles. The connector 100 and connection assembly 1000 can connect a cooled electrical cable 110 to a cooled busbar 140, e.g. while maintaining high heat transfer between the conductor(s) and the coolant 130.

Herein, a clamp can provide a radially inward force, e.g. by being crimped to the annularly disposed conductor. The clamp described herein can be a circumferential clamp and/or ferrule.

Herein, "cooled" means configured for cooling, e.g. for thermal coupling to a coolant, e.g. a fluid coolant. "Cooled," herein, can mean configured for passing a fluid coolant therethrough, or coupleable to a device or structure that supports flow of a fluid coolant. For example, a cooled electrical cable can include a hose which is configured for passing a coolant therethrough. The cooled electrical cable can transfer heat to the coolant, e.g. resistive heat generated by current passing through a conductor of the cooled electrical cable.

Herein, being "along the mating direction" can be parallel to the mating direction, particularly when describing relationships between annularly disposed features - similarly, for "along the coupling direction."

Herein "busbar" and "cooled busbar" can be used interchangeably.

Herein "long axis" and "longitudinal axis", e.g. of the cable can be used interchangeably. The cable can be flexible such that the long axis curves with the cable.

Herein "cooled cable", "cooled electrical cable", and "cable" can be used interchangeably, and refer to an electrical cable that includes a hose for passing a coolant therein. The cables described herein can include an annularly disposed conductor around a hose. The cooled electrical cable described herein may include exactly one hose for a coolant, and the singular hose may be at the center of the cooled electrical cable. The connector may include exactly one hose fitting for the sole central hose of the cooled electrical cable. The connector and busbar described herein may each include exactly one inlet and one outlet for passing a coolant, respectively, therethrough.

Herein, a trailing "(s)" is used to indicate one or more. For example, a "washer(s)" means one or more washers. Herein a slash can indicate "and/or". "And/or" means "'and' or 'or'". For example, "clamp/seal" can mean "to clamp", "to seal", or "to clamp and seal".

**Reference Numerals**

| | |
|---|---|
| connection assembly | 1000 |
| connector | 100 |
| cooled electrical cable (e.g. HV cable) | 110 |
| cable sheath (e.g. outer insulation) | 112 |
| cable shield (e.g. shield mesh) | 114 |
| insulator (e.g. inner insulation) | 115 |
| cable conductor | 116 |
| cable hose | 118 |
| terminal body | 120 |
| first orifice | 122 |
| second orifice | 124 |
| coolant | 130 |
| cooled busbar | 140 |
| channel | 150 |
| clamp | 160 |
| busbar coupling | 180 |
| hose fitting | 190 |
| mating direction | 199 |
| mating axis | 199' |
| radially outward surface of inlet | 210 |
| hose mating surface | 220 |
| electrical contact surface of terminal body | 230 |
| corrugations and/or barbs | 240 |
| o-ring | 250 |
| annular spring | 260 |
| flange | 270 |
| step | 280 |
| cylindrical conduit of the terminal body | 290 |
| coupling axis | 299' |
| coolant channel of cable hose | 350 |
| longitudinal axis of the cable | 399 |
| bolt | 410 |
| flange for busbar coupling | 420 |
| housing assembly | 500 |
| duct | 510 |
| duct orifice | 512 |
| second duct orifice | 514 |
| washer(s) | 520, 530 |
| head of the bolt | 540 |
| housing | 550 |
| shield coupling | 560 |
| safety block | 570 |
| opening of the housing | 580 |

## Claims

1. A connector (100) for electrically and fluidly connecting a cooled electrical cable (110) to a cooled busbar (140), comprising:
a terminal body (120), the terminal body (120) including:
a first and second orifice (122, 124);
a channel (150) extending through the terminal body (120), the channel (150) connecting the first and second orifices (122, 124), the channel (150) configured to pass a coolant (130) between the cooled electrical cable (110) and the cooled busbar (140); and
a hose fitting (190) configured to couple the terminal body (120) to a hose (118) of the cooled electrical cable (110), the hose fitting (190) including the first orifice (122); wherein
the connector (100) further comprises:
a busbar coupling (180) configured to couple the terminal body (120), at the second orifice (124), to the cooled busbar (140); and
a clamp (160) configured to sandwich an annularly disposed electrical conductor (116) of the cable (110) between the clamp (160) and the terminal body (120) adjacent to the hose fitting (190).

2. The connector (100) of claim 1, wherein
the terminal body (120) includes an electrical contact surface (230), which is an outer surface adjacent to the hose fitting (190); wherein
the electrical contact surface (230) is configured to electrically contact the annularly disposed electrical conductor (116) of the cable (110).

3. The connector (100) of claim 2, wherein
the clamp (160) is configured to provide a radially inward force toward an electrical contact surface (230) of the terminal body (120).

4. The connector (100) of claim 2 or 3, wherein
the electrical contact surface (230) includes a metal finish.

5. The connector (100) of any one of claims 1-4, wherein
the hose fitting (190) is configured to be inserted into the hose (118) along a mating direction (199) along a mating axis (199').

6. The connector (100) of any one of claims 1-5, wherein
a hose mating surface (220) of the hose fitting (190) is annular, in a cross-section perpendicular to the mating axis (199').

7. The connector (100) of claim 6, wherein
the hose mating surface (220) of the hose fitting (190) is barbed.

8. The connector (100) of any one of claims 1-7, wherein:
the busbar coupling (180) is configured to fluidly and sealingly couple the second orifice (124) to the cooled busbar (140).

9. The connector (100) of any one of claims 1-8, wherein:
the busbar coupling (180) includes, annularly disposed around a coupling axis (299'), at least one of:
an o-ring (250), an annular spring (260), or a washer (520, 530).

10. The connector (100) of claim 9, wherein
at least one of the o-ring (250) or the annular spring (260) is disposed annularly around the channel (150), and, at least one of:
the o-ring (250) is configured to form a seal with the cooled busbar (140);
the annular spring (260) is configured to form a seal with the cooled busbar (140); or
the annular spring (260) is configured to form an electrical contact between the cooled busbar (140) and the connector (100).

11. The connector (100) of claim 9 or 10, wherein
at least one of the o-ring (250) or the annular spring (260) is separated from the channel (150) by a cylindrical conduit (290) of the terminal body (120); wherein
the cylindrical conduit (290) extends to the second orifice (124).

12. The connector (100) of any one of claims 1-11, wherein
the busbar coupling (180) includes a bolt (410) that extends parallel to the coupling axis (299'); wherein
the bolt (410) is configured to fasten the connector (100) to the cooled busbar (140).

13. The connector (100) of claim 12, wherein:
the bolt (410) extends along the coupling axis (299'), and
the bolt (410) extends through the second orifice (124), and
the bolt (410) includes a duct (510) configured to pass the coolant (130) between the cooled electrical cable (110) and the cooled busbar (140).

14. A connection assembly (1000), comprising:
the connector (100) of any one of claims 1-13;
the cooled busbar (140); and
the cooled electrical cable (110) which includes the hose (118) and the electrical conductor (116); wherein
the electrical conductor (116) is annularly disposed around the hose (118) and the hose fitting (190) and the electrical contact surface (230); and wherein
the electrical conductor (116) extends to the electrical contact surface (230) of the terminal body (120) of the connector (100), and the clamp (160).

15. The connection assembly (1000) of claim 14, further comprising:
a housing (550), which includes an opening (580) through which the hose (118) and the electrical conductor (116) of the cooled electrical cable (110) passes to the connector (100).
